# EUROPEAN PATENT APPLICATION

(11) **EP 4 672 905 A1**
(43) Date of publication of application: **31.12.2025**
(21) Application number: 25184984.0
(22) Date of filing: 24.06.2025
(51) Int. Cl.: H10D 62/10, H01L 21/02, H10D 30/01, H10D 30/67, H10D 88/00, H10D 62/80, H10D 30/69, H10D 30/47

(54) **TECHNOLOGIES FOR A RIBBON FIELD EFFECT TRANSISTOR WITH TWO-DIMENSIONAL ELECTRON OR HOLE GAS CHANNELS**

(30) Priority: 26.06.2024 US 202418755135
(71) Applicant: Intel Corporation, Santa Clara, CA 95054 (US)
(72) Inventor: STEINHARDT, Rachel A., Beaverton, 97006 (US); BURAGOHAIN, Pratyush P., Portland, 97212 (US); O'BRIEN, Kevin P., Portland, 97209 (US); ADAMS, Dominique A., Portland, 97206 (US); CHO, Karam, Hillsboro, 97006 (US); CLENDENNING, Scott B., Portland, 97225 (US); DEBASHIS, Punyashloka, San Jose, 95134 (US); HARLSON, Shane, Beaverton, 97003 (US); KIM, Raseong, Lake Oswego, 97034 (US); METZ, Matthew V., Portland, 97229 (US); PLOMBON, John J., Portland, 97219 (US); RADOSAVLJEVIC, Marko, Portland, 97229 (US); ROGAN, Carly, North Plains, 97133 (US); RYU, Hojoon, Hillsboro, 97124 (US); SEN GUPTA, Arnab, Hillsboro, 97123 (US); TRONIC, Tristan A., Aloha, 97003 (US); TUNG, I-Cheng, Hillsboro, 97124 (US); YOUNG, Ian Alexander, Olympia, 98512 (US)
(74) Representative: 2SPL Patentanwälte PartG mbB

(57) **Abstract**

Technologies for a field effect transistor (FET) with a two-dimensional electron gas (2DEG) or a two-dimensional hole gas (2DHG) are disclosed. In an illustrative embodiment, channel fins of a ribbon FET include two perovskite layers. At an interface between the perovskite layers, a 2DEG or a 2DHG is formed. The 2DEG or 2DHG can act as a channel for an NMOS or PMOS transistor, respectively. In some embodiments, an NMOS transistor with a 2DEG channel can be combined with a PMOS transistor with a 2DHG channel can be combined in a CMOS system. Additionally, methods of manufacturing such transistors are disclosed.

## Description

### BACKGROUND

Transistors are ubiquitous devices present in virtually all electronic devices. As the density of transistors continues to increase, the power dissipated by the transistors needs to be addressed. The power dissipation of a transistor can be reduced in several ways, such as reducing leakage current and reducing the threshold voltage of the transistor.

A typical transistor can maintain its state when a voltage is maintained at a gate electrode. However, a ferroelectric field-effect transistor (FEFET) can maintain its state based on the state of a ferroelectric layer in the transistor. FEFETs typically have a relatively high threshold voltage and a corresponding relatively high leakage current.

### BRIEF DESCRIPTION OF THE DRAWINGS

FIG. 1 is an isometric view of a ribbon field-effect transistor (FET).
FIG. 2 is a cross-sectional side view of one embodiment of the transistor of FIG. 1.
FIG. 3 is a cross-sectional side view of one embodiment of the transistor of FIG. 1.
FIG. 4 is a cross-sectional side view of one embodiment of the transistor of FIG. 1.
FIG. 5 is a simplified flow diagram of at least one embodiment of a method for creating a ribbon FET.
FIG. 6 is a cross-sectional side view at one step of manufacturing the transistor of FIG. 1.
FIG. 7 is a cross-sectional side view at one step of manufacturing the transistor of FIG. 1.
FIG. 8 is a simplified flow diagram of at least one embodiment of a method for creating a ribbon FET.
FIG. 9 is a cross-sectional side view at one step of manufacturing the transistor of FIG. 1.
FIG. 10 is a cross-sectional side view at one step of manufacturing the transistor of FIG. 1.
FIG. 11 is a cross-sectional side view at one step of manufacturing the transistor of FIG. 1.
FIG. 12 is a cross-sectional side view at one step of manufacturing the transistor of FIG. 1.
FIG. 13 is a top view of a wafer and dies that may be included in a microelectronic assembly, in accordance with any of the embodiments disclosed herein.
FIG. 14 is a cross-sectional side view of an integrated circuit device that may be included in a microelectronic assembly, in accordance with any of the embodiments disclosed herein.
FIGS. 15A-15D are perspective views of example planar, FinFET, gate-all-around, and stacked gate-all-around transistors.
FIG. 16 is a cross-sectional side view of an integrated circuit device assembly that may include a microelectronic assembly, in accordance with any of the embodiments disclosed herein.
FIG. 17 is a block diagram of an example electrical device that may include a microelectronic assembly, in accordance with any of the embodiments disclosed herein.

### DETAILED DESCRIPTION

In one embodiment disclosed herein, as described in more detail below, the channel of a field-effect transistor (FET) is defined at an interface between two perovskites, such as barium stannate (BaSnO₃ or BSO) and lanthanum scandium oxide (LaScO₃ or LSO). In some embodiments, at the interface between the BSO and the LSO, a two-dimensional electron gas (2DEG) is formed, which can be used as a channel in an NMOS transistor. In other embodiments, depending on factors such as the stacking order, at the interface between the BSO and the LSO, a two-dimensional hole gas (2DHG) is formed, which can be used as a channel in a PMOS transistor. In some embodiments, NMOS transistors with the 2DEG and PMOS transistors with the 2DHG may be used together in a CMOS device. Different approaches for forming such structures is described below.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact, and "coupled" may indicate elements co-operate or interact, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, a substrate assembly feature, such as a through width, that is described as having substantially a listed dimension can vary within a few percent of the listed dimension.

As used herein, the phrase "communicatively coupled" refers to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate and an integrated circuit component attached to a printed circuit board that send signals to or receives signals from other integrated circuit components or electronic devices attached to the printed circuit board.

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

As used herein, the terms "upper" / "lower" or "above" / "below" may refer to relative locations of an object (e.g., the surfaces described above), especially in light of examples shown in the attached figures, rather than an absolute location of an object. For example, an upper surface of an apparatus may be on an opposite side of the apparatus from a lower surface of the object, and the upper surface may be facing upward generally only when viewed in a particular way. As another example, a first object above a second object may be on or near an "upper" surface of the second object rather than near a "lower" surface of the object, and the first object may be truly above the second object only when the two objects are viewed in a particular way.

References are made to the drawings, which are not necessarily drawn to scale, wherein similar or same numbers may be used to designate the same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

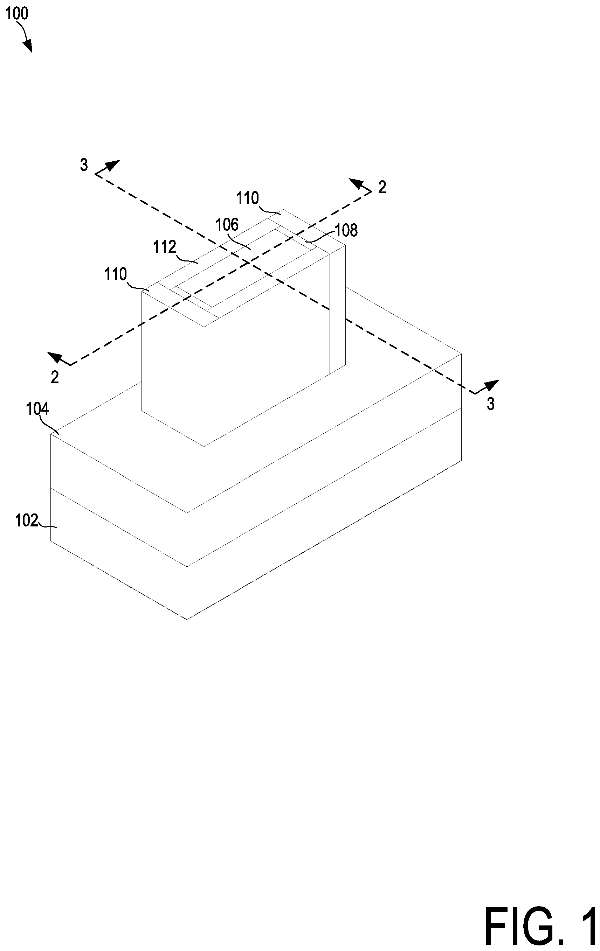

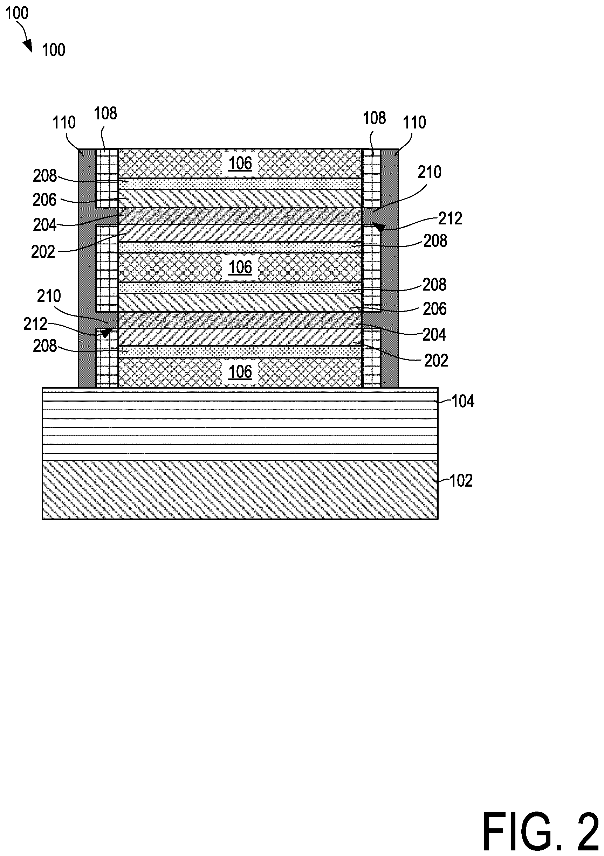

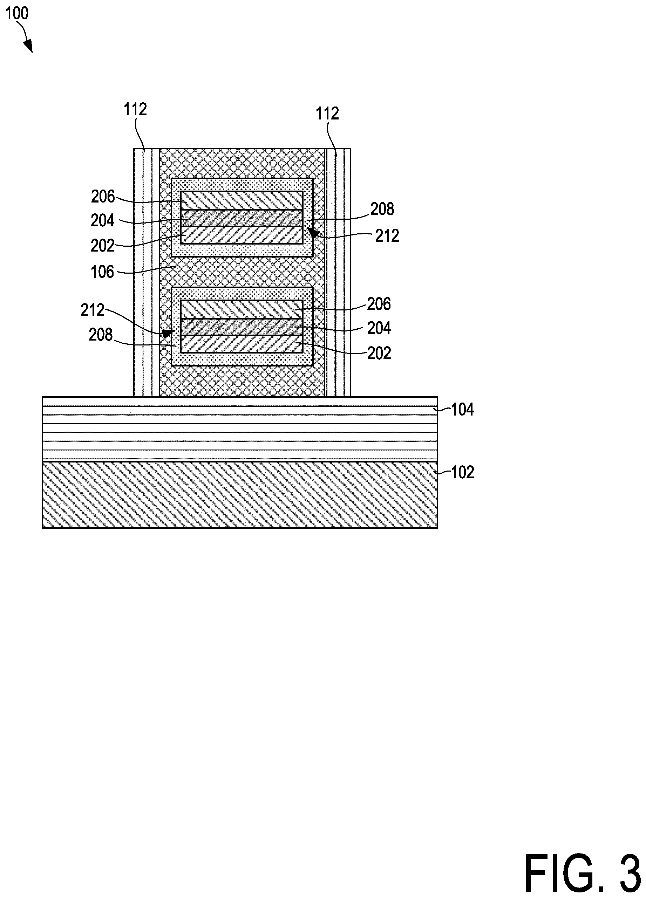

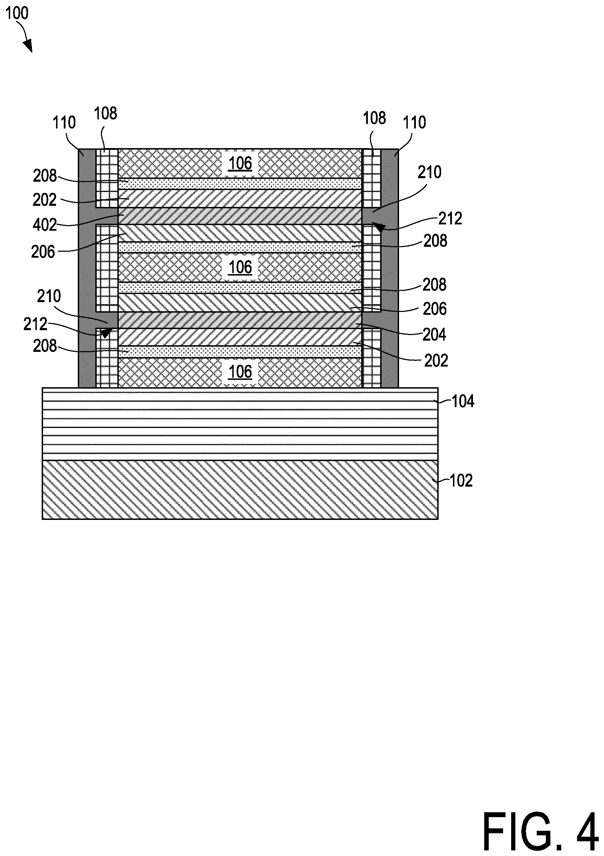

Referring now to FIGS. 1-4, in one embodiment, FIG. 1 shows a perspective view of a ribbon FET 100, FIG. 2 shows a cross-sectional view of the ribbon FET 100 taken from view 2 labeled in FIG. 1, FIG. 3 shows a cross-sectional view of one embodiment of the ribbon FET 100 taken from view 3 labeled in FIG. 1, and FIG. 4 shows a cross-sectional view of another embodiment of the ribbon FET 100 taken from the same view as FIG. 3. In some embodiments, the ribbon FET 100 may also be referred to as a gate-all-around transistor, a nanowire transistor, a nanosheet transistor, etc.

The ribbon FET 100 is supported by a substrate 102 and a buffer layer 104. The ribbon FET 100 has one or more channel fins 212. In an illustrative embodiment, the channel fins 212 include a first perovskite layer 202 and a second perovskite layer 206. A region 204 of the first perovskite layer 202 near the interface between the perovskite layers 202, 206 acts as a two-dimensional electron gas (2DEG) channel for the transistor 100. Metal contact layers 110 are disposed at either end of the channel fins 212. Source/drain contacts 210 extend from the metal contact layers 110 and are adjacent to the 2DEG channel 204. Dielectric layer 208 surrounds the channel fins 212, and a gate layer 106 surrounds the dielectric layer 208, as shown in FIG. 3. In some embodiments, the dielectric layer 208 may be a ferroelectric layer 208. In the illustrative embodiment, the dielectric layer 208 is conformal to the channel fins 212, and the gate layer 106 is conformal to the dielectric layer 208. Dielectric spacers 108 and dielectric spacers 112 are disposed between the metal contact layers 110 and other parts of the ribbon FET 100, such as the layers 202, 206 of the channel fins 212 and the gate layer 106.

In use, a voltage can be applied to the gate layer 106, which causes an electric field to be applied to the dielectric layer 208 and to the channel 212 and 2DEG 204. The electric field can change the conductivity of the channel 204, turning the ribbon FET 100 on or off. In embodiments in which the dielectric layer 208 is ferroelectric, if the applied voltage causes an electric field above a coercive field, the direction of the spontaneous polarization of the ferroelectric material can switch. The electric displacement of the ferroelectric material is the spontaneous polarization of the ferroelectric when no electric field is applied by the gate layer 106. Under the applied field from the voltage of the gate layer 106, the electric displacement of the ferroelectric material increases. As a result, the electric displacement applied to the channel 204 is affected by the polarization state of the ferroelectric material of the ferroelectric layer 208, and, therefore, the current through the channel 204 is affected by the polarization state of the ferroelectric material of the ferroelectric layer 208. This property can be used to facilitate low-threshold switching, single transistor memory, and compute-in-memory.

A perovskite material is any crystalline material with a crystal structure similar to calcium titanate (CaTiO₃), typically with the chemical formula of ABX₃, where A is one element, B is a second element, and X is a third element. In some cases, some of one (or more) of element A, B, or X in a perovskite material may be replaced by a different element. For example, in one embodiment, Pb(Zr*ₓ*Ti_{1*-x*})O₃ (i.e., lead zirconate titanate or PZT) can have both zirconium and titanium as element B, with a varying amount of each depending on the value of *x.* A perovskite material may have various cation pairings, such as A⁺B²⁺X⁻₃, A²⁺B⁴⁺X²⁻₃, A³⁺B³⁺X²⁻₃, or A⁺B⁵⁺X²⁻₃.

In the illustrative embodiment, the first perovskite layer 202 is barium stannate (BaSnO₃ or BSO), and the second perovskite layer 206 is lanthanum scandium oxide (LaScO₃ or LSO). At the interface between the LSO 206 and the BSO 202, a 2DEG 204 is formed. The 2DEG 204 is used as a channel in the ribbon FET 100. It should be appreciated that the region 204 is part of the BSO layer 202.

In an illustrative embodiment, some or all of the BSO layer 202, including the channel 204, is doped, such as doped with lanthanum. In other embodiments, the layer 202 may be made from other materials, such as lanthanum-doped SrSnO₃ or lanthanum-doped (BaSr)SnO₃. In some embodiments, additionally or alternatively, the layer 202 may be doped with a different element, such as Nd, Ce, Cs, Y, V, K, Co, etc.

In some embodiments, the perovskite layer 206 may be any suitable perovskite, such as LaScO₃, LaAlO₃, LaInO₃. In some embodiments, the perovskite layer 206 may have the form ReXO₃, where Re is a lanthanide, or the layer 206 may be any similar material.

The dielectric spacers 108, 112 are a low-k material such as, e.g., silicon oxide, silicon nitride, silicon oxycarbonitride, and/or the like. In other embodiments, the dielectric spacers 108, 112 may be made from a material with a similar lattice constant as the channel fins 212 to facilitate growth of high-quality crystals of the doped semiconductor of the channel fins 212.

The substrate 102 supports the buffer layer 104 and the rest of the transistor 100. In the illustrative embodiment, the substrate 102 is silicon. In other embodiments, the substrate 102 may be, e.g., silicon oxide, gallium nitride, a perovskite, strontium titanium oxide, etc.

The buffer layer 104 may be any suitable material on which the various layers of the transistor 100 are grown. The buffer layer 104 may be lattice matched to the lattice parameter of various layers such as the perovskite layers 202, 206. In the illustrative embodiment, the buffer layer 104 is strontium titanium oxide (SrTiO₃ or STO or strontium titanate). In some embodiments, the buffer layer 104 may be referred to as a substrate.

In the illustrative embodiment, the transistor 100 is symmetric, and there is no functional distinction between the source region and the drain region. The fins 212 may have any suitable dimensions, such as a thickness or width of, e.g., 5-20 nanometers and a length of, e.g., 2-50 nanometers. The transistor may include any suitable number of fins 212, such as 1-5. The 2DEG region 204 of the perovskite layer 202 may have any suitable thickness, such as 2-5 nanometers.

The illustrative gate layer 106 is a metallic perovskite or other metal, such as SrRuO₃, LaNiO₃, LaRuO₃, SrVO₃, SrCoO₃, SrMoO₃, lanthanum strontium manganite (La₁₋ₓSrₓMnO₃ or LSMO), lanthanum strontium cobalt oxide (La₁₋ₓSrₓCoO₃ or LSCO), SrFeO₃, ReO₃ (where Re may be Dy, Tb, Gd, Eu, Sm, Nd, Pr, Ce, or La), CaRuO₃, SrNbO₃, ruthenium, ruthenium oxide, iridium, iridium oxide, platinum, palladium, molybdenum, molybdenum oxide, rhodium, rhenium, tungsten, etc. In some embodiments, the work function of the gate layer 106 is selected to shift the coercive voltage across the ferroelectric layer 208.

The illustrative contact layers 110 and source/drain contacts 210 may be made of any suitable material. In an illustrative embodiment, the contact layers 110 and source/drain contacts 210 are metallic, such as nickel silicide, cobalt silicide, titanium silicide, tungsten, titanium, etc.

The dielectric layer 208 may be any suitable dielectric, such as a high-K dielectric. In embodiments in which the dielectric layer 208 is ferroelectric, the ferroelectric layer 208 may be any suitable ferroelectric, such as a perovskite ferroelectric. In an illustrative embodiment, the ferroelectric layer 208 may be barium titanate (BaTiO₃ or BTO) or bismuth ferrite (BiFeO₃ or BFO). In other embodiments, the ferroelectric layer 208 may be a different material, such as lead zirconate titanate (Pb(ZrₓTi₁₋ₓ)O₃ or PZT), lead niobate zirconate titanate ((Pb₁₋ₓNbₓ)(Zr_{1-y}Ti_{y})O₃ or PNZT), lead lanthanum zirconate titanate ((Pb₁₋ₓLaₓ)(Zr_{1-y}Ti_{y})O₃ or PLZT), lanthanum bismuth ferrite (LaₓBi₁₋ₓFeO₃ or LaBFO), bismuth iron cobaltate (BiFe₁₋ₓCoₓO₃), lithium or potassium niobate (LiNbO₃ or KNbO₃), CaNbTi₂O₆, Pb₂BiNbO₆, Ca₃Nb₂N₂O₅, Bi₄Ti₃O₁₂, Ba(Hf,Ti)O₃, (Ba,Ca)(ZrTi)O₃, GdFeO₃, (Gd,La)FeO₃, etc., and combinations thereof. In some embodiments, the layer 208 may be a dielectric layer with two or more sublayers, such as a linear dielectric layer and a ferroelectric layer. The linear dielectric layer may facilitate lattice matching for the ferroelectric and/or may reduce leakage current between the channel 204 and the gate layer 106.

In some embodiments, a separate dielectric layer 208 may not be included. Rather, the perovskite layers 202, 206 other than the 2DEG region 204 may act as the gate dielectric.

In the illustrative embodiment, the various elements or dopants of the ferroelectric layer 208 are uniformly distributed throughout the ferroelectric layer 208. In other embodiments, dopants or other elements may have a concentration gradient, which may improve device performance.

The ferroelectric layer 208 may have any suitable coercive field, such as 50-500 kV/cm. The ferroelectric layer 208 may be any suitable thickness. The dielectric layer 208 may have any suitable thickness, such as a thickness of about 0.5-25 nanometers.

The threshold voltage of the transistor 100 depends on the dielectric and/or ferroelectric layer 208 material as well as the channel 212 thickness and doping concentration. The threshold voltage of the transistor 100 may be any suitable value, such as 0.2-5 volts, depending on the materials used.

In some embodiments, the polarization of the ferroelectric of the ferroelectric layer 208 switches all at once in a few picoseconds. In other embodiments, the ferroelectric of the ferroelectric layer 208 may have multiple domains that may switch at different applied electric fields (and, therefore, at different times). In such embodiments, the ferroelectric of the ferroelectric layer 208 may have multiple stable states that can be set by applying a particular voltage to the gate layer 106. Such a transistor 100 can act as a multi-level memory or like an analog memory.

In the embodiments described above, the fins 212 include an LSO layer 206 formed on top of a BSO layer 202, and part of the BSO layer 202 forms a 2DEG region 204. Additionally or alternatively, in another embodiment, some or all of the fins 212 may include an LSO layer 206 formed on top of a BSO layer 202, and part of the BSO layer 202 forms a two-dimensional hole gas (2DHG) region 402, as shown in FIG. 4. Whether the interface between the LSO layer 206 and the BSO layer 202 forms a 2DEG or a 2DHG may depend on factors such as the band structure of the materials, which layer is deposited on which, the particular crystal structure including the elemental termination at the interface, the presence or absence of oxygen vacancies, etc. For example, in one embodiment, with an LSO layer 206 grown on a BSO layer 202, the termination layer of the lower layer may favor formation of a 2DEG, while, with a BSO layer 202 grown on an LSO layer 206, the termination layer of the lower layer may favor formation of a 2DHG.

It should be appreciated that the ribbon FET 100 described above is merely one possible embodiment, and other embodiments are envisioned as well. For example, in one embodiment, a top-gate FET or fin FET may include a channel that includes a first perovskite layer 202 and a second perovskite layer 206 with a 2DEG or 2DHG channel region 204 at an interface between the perovskite layers 202, 206.

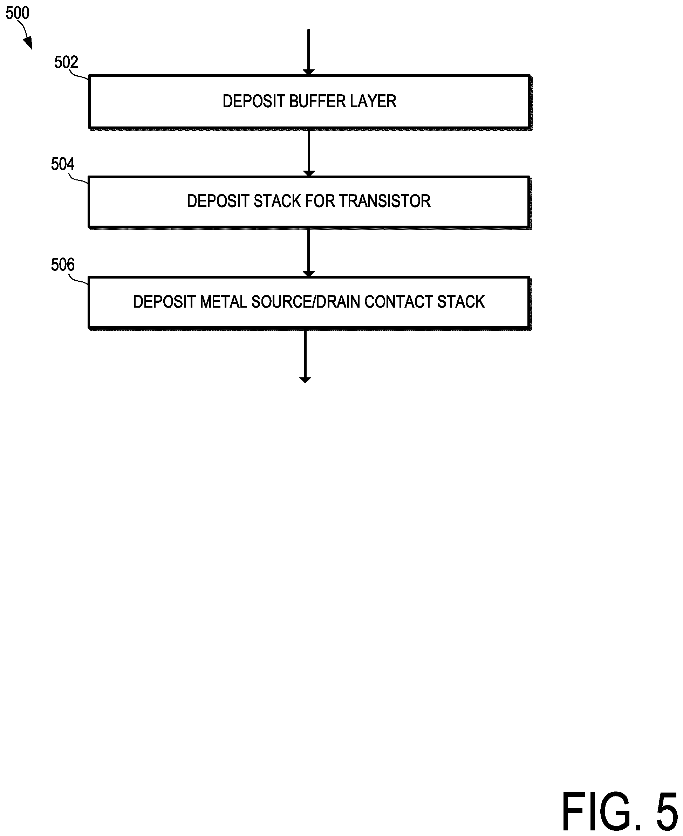

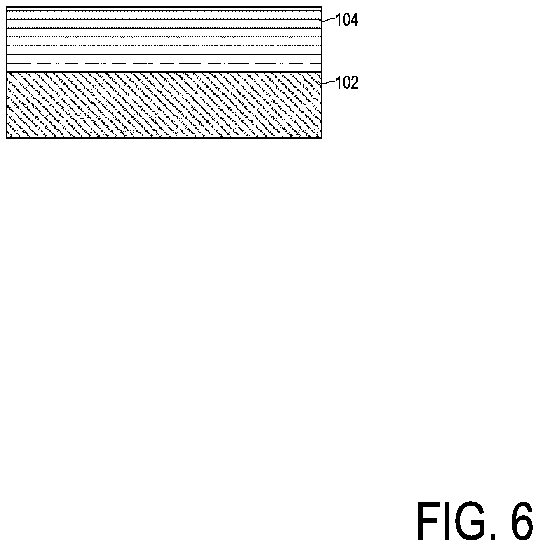

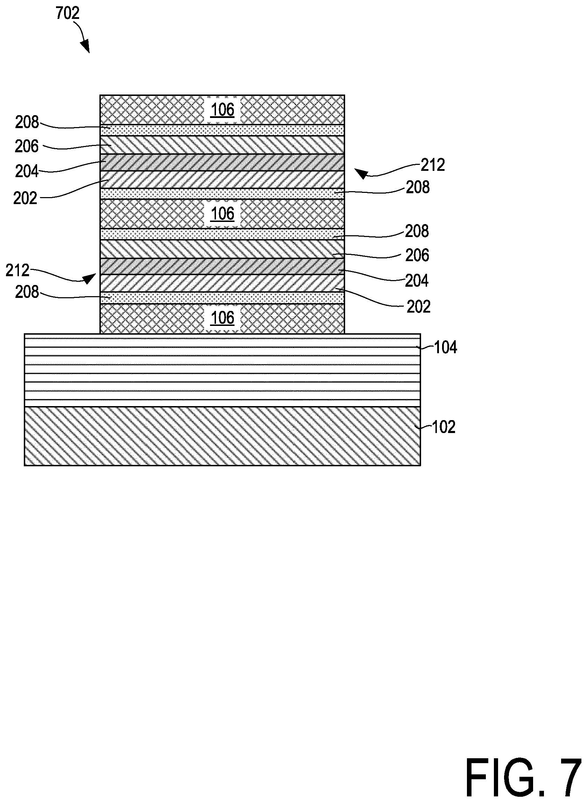

Referring now to FIG. 5, in one embodiment, a flowchart for a method 500 for creating a transistor (such as transistor 100) is shown. The method 500 may be executed by a technician and/or by one or more automated machines. In some embodiments, one or more machines may be programmed to do some or all of the steps of the method 500. Such a machine may include, e.g., a memory, a processor, data storage, etc. The memory and/or data storage may store instructions that, when executed by the machine, causes the machine to perform some or all of the steps of the method 500. The method 500 may use any suitable set of techniques that are used in semiconductor processing, such as chemical vapor deposition, atomic layer deposition, physical vapor deposition, molecular beam epitaxy, pulsed laser deposition, layer transfer, photolithography, ion implantation, dry etching, wet etching, thermal treatments, etc. FIGS. 6 and 7 show various stages of the method 500 as it is used to create a transistor.

The method 500 begins in block 502, in which a buffer layer 104 is deposited on a substrate 102, as shown in FIG. 6. The buffer layer 104 may be deposited in any suitable manner, such as chemical vapor deposition, atomic layer deposition, physical vapor deposition, molecular beam epitaxy, pulsed laser deposition, etc. In some embodiments, the buffer layer 104 is deposited using layer transfer.

In block 504, a stack 702 is applied, as shown in FIG. 7. The layers of the stack 702 may be grown in any suitable manner, such as molecular beam epitaxy, chemical vapor deposition, atomic layer deposition, physical vapor deposition, pulsed laser deposition, etc. The stack 702 may be applied to form a 2DEG in some or all of the channel fins 212. Additionally or alternatively, some or all of the stack 702 may be applied to form a 2DHG in some or all of the channel fins 212.

In block 506, a metal source/drain contact stack may be deposited, resulting in the transistor shown in FIG. 2. The metal layer 110, dielectric layer 108, and source/drain contacts 210 may be deposited in any suitable manner, such as building the stack bottom-up in several steps. In other embodiment, the metal layer 110 may be deposited, part of the metal layer may be removed, leaving the source/drain contacts 210, and the dielectric layer 108 may fill in the part of the metal layer 110 that was removed.

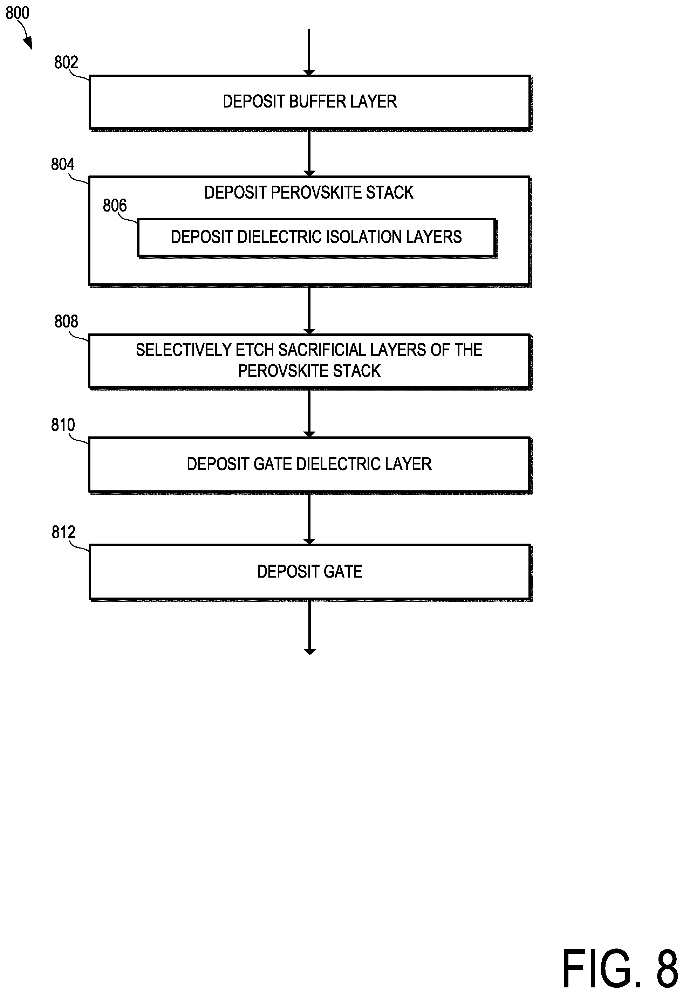

Referring now to FIG. 8, in one embodiment, a flowchart for a method 800 for creating a transistor (such as transistor 100) is shown. The method 800 may be executed by a technician and/or by one or more automated machines. In some embodiments, one or more machines may be programmed to do some or all of the steps of the method 800. Such a machine may include, e.g., a memory, a processor, data storage, etc. The memory and/or data storage may store instructions that, when executed by the machine, causes the machine to perform some or all of the steps of the method 800. The method 800 may use any suitable set of techniques that are used in semiconductor processing, such as chemical vapor deposition, atomic layer deposition, physical vapor deposition, molecular beam epitaxy, pulsed laser deposition, layer transfer, photolithography, ion implantation, dry etching, wet etching, thermal treatments, etc.

The method 800 begins in block 802, in which a buffer layer 104 is deposited on a substrate 102, as shown in FIG. 6. The buffer layer 104 may be deposited in any suitable manner, such as chemical vapor deposition, atomic layer deposition, physical vapor deposition, molecular beam epitaxy, pulsed laser deposition, etc. In some embodiments, the buffer layer 104 is deposited using layer transfer.

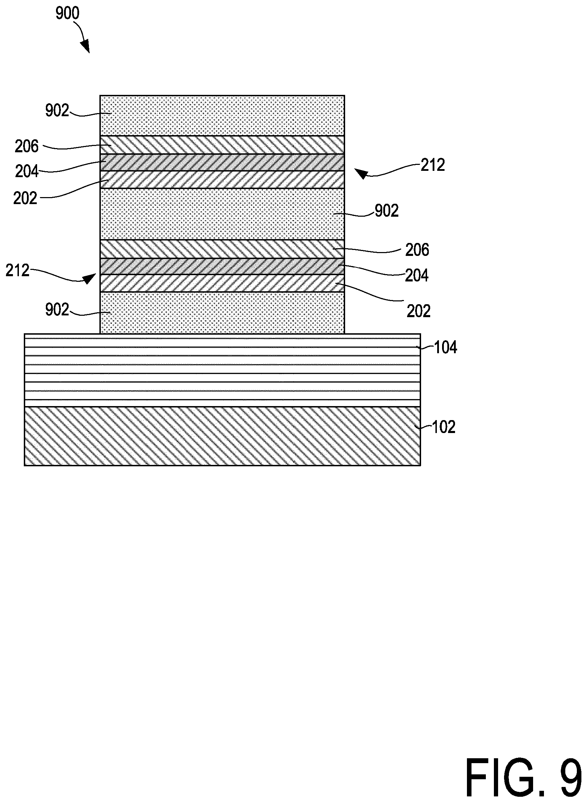

In block 804, a perovskite stack 900 is applied, as shown in FIG. 9. The layers of the stack 900 may be grown in any suitable manner, such as molecular beam epitaxy, chemical vapor deposition, atomic layer deposition, physical vapor deposition, pulsed laser deposition, etc. In the illustrative embodiment, the perovskite stack 900 includes channel fins 212 alternating with sacrificial layers 902. In an illustrative embodiment, every layer in the perovskite stack 900 is a perovskite layer, which can improve lattice matching and reduce defects.

The perovskite stack includes sacrificial layers 902, which may be any suitable material on which the channel fins 212 can be deposited with high-quality crystal growth and which can be etched away while leaving at least some or all of the channel fins 212. For example, the sacrificial layers 902 may include SrTiO₃, BaTiO₃, BaHfO₃, BaZrO₃, LaAlO₃, LaCoO₃, SrSnO₃, and alloys or doped versions thereof. In some embodiments, the sacrificial layers 902 may be water-soluble perovskites.

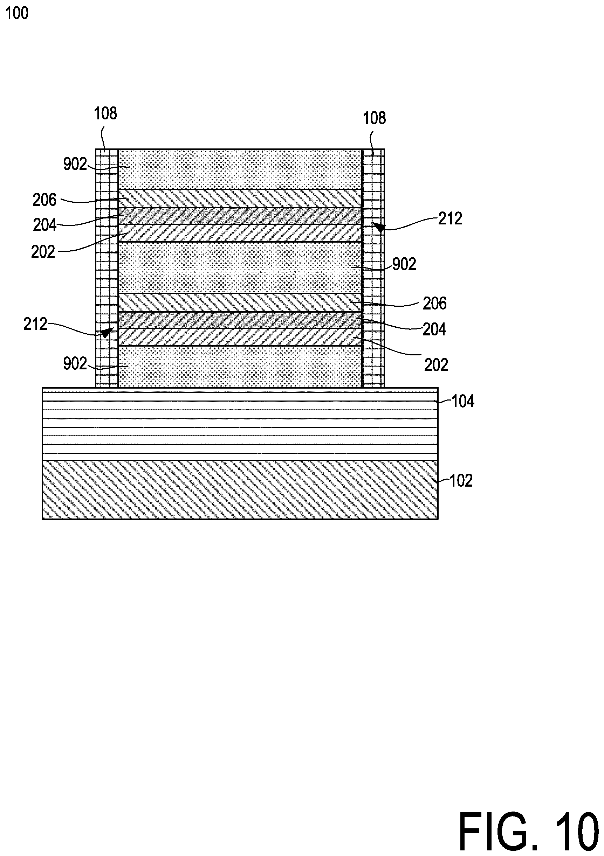

In block 806, dielectric isolation layers 108 may be deposited, as shown in FIG. 10.

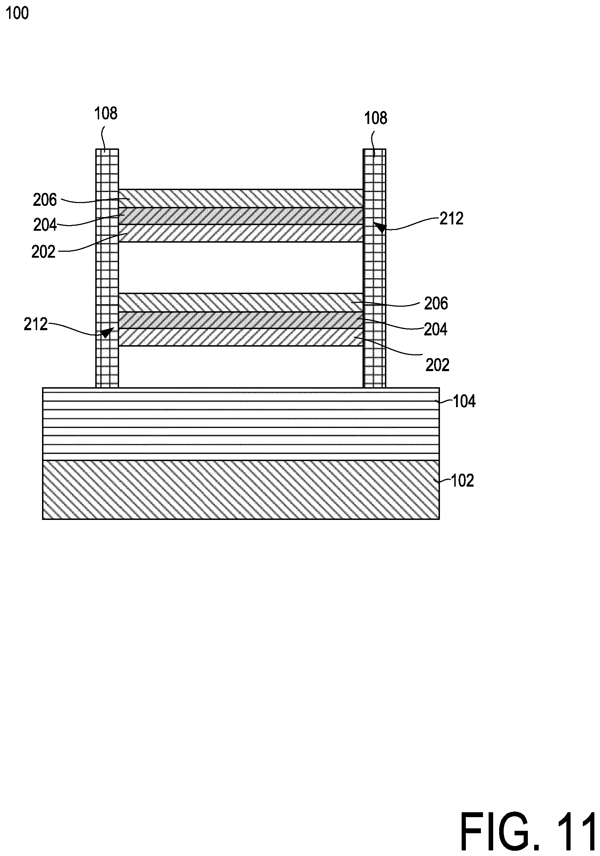

In block 808, the sacrificial layers 902 of the perovskite stack 900 are selectively etched, leaving behind most or all of the channel fins 212, as shown in FIG. 11. The sacrificial layers 902 may be etched in any suitable manner, such as using wet etchants, a dry chemical vapor etch, or an atomic layer etch. Wet etchants may be, e.g., dilute hydrofluoric acid or hydrochloric acid. A dry chemical vapor etch of the sacrificial layers 902 may be achieved using etch ligands such as acetylacetone (Hacac), hexafluoroacetylacetone (Hhfac) along with co-reactants such as water and hydrogen peroxide vapor.

In block 810, the gate dielectric layer 208 is deposited. The gate dielectric layer 208 may be any suitable dielectric or ferroelectric material, such as those listed above, which will not be repeated in the interest of clarity. In the illustrative embodiment, the gate dielectric layer 208 is deposited conformally on the channel fins 212 and the dielectric isolation layers 108. In the illustrative embodiment, the gate dielectric layer 208 is lattice-matched with the channel fins 212, forming a high-quality interface between the gate dielectric 208 and the channel fins 212 and a high-quality crystal for the gate dielectric layer 208. The gate dielectric layer 208 may be deposited using any suitable precursor. For example, if the gate dielectric layer 208 is to be BaTiO₃, precursors such as Ba(thd)₂ (where thd is 2,2,6,6-tetramethyl-3,5-heptanedionate) and Ti(OMe)₄ (where Me is CH₃) may be used with ozone as a co-reactant. As the gate dielectric layer 208 is built up layer by layer, dopants may be introduced in the gate dielectric layer 208 by adding in ALD cycles of the doping metal precursor and ozone. Depending on the overall pulse sequence used, the dopant may be uniformly distributed throughout the gate dielectric layer 208 or introduced in a graded fashion in order to improve device performance.

In some embodiments, the layer 208 is deposited as two or more sublayers, such as a linear dielectric layer and a ferroelectric layer. The linear dielectric layer may facilitate lattice matching for the ferroelectric and/or may reduce leakage current between the channel fins 212 and the gate layer 106.

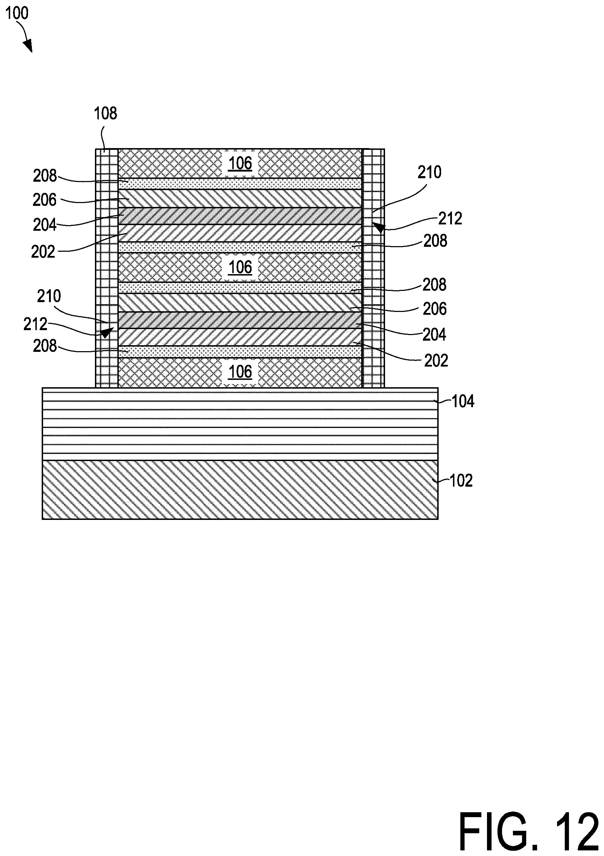

In block 812, the gate layer 106 is deposited, as shown in FIG. 12. The gate layer 106 may be any suitable material, such as those listed above, which will not be repeated in the interest of clarity. In the illustrative embodiment, the gate layer 106 is conformal to the gate dielectric layer 208 and is applied using any suitable atomic layer deposition technique. In some embodiments, the gate layer 106 may be lattice matched to the gate dielectric layer 208, and the interface between the gate layer 106 and the gate dielectric layer 208 as well as the crystal structure of the gate layer 106 are high quality. In other embodiments, the gate layer 106 may not be lattice matched with the dielectric layer 208, and the interface between the layers 106, 208 may have a relatively large amount of defects.

It should be appreciated that the methods 500, 800 are just some of many possible embodiments of manufacturing the transistor 100. Different approaches or orders of steps are envisioned as well. The steps of the methods 500, 800 may be done in a different order or the methods 500, 800 may include different steps for different embodiments of the transistor 100. It should be appreciated that a complete manufacturing process of an integrated circuit that includes the transistor 100 may include steps not shown in the methods 500, 800, such as polishing/etching to form a flat surface, cleaning, surface passivation, adding electrodes to the source regions and gate regions of the fins 212, adding electrodes for the gate layer 106, creating interconnects, packaging, etc.

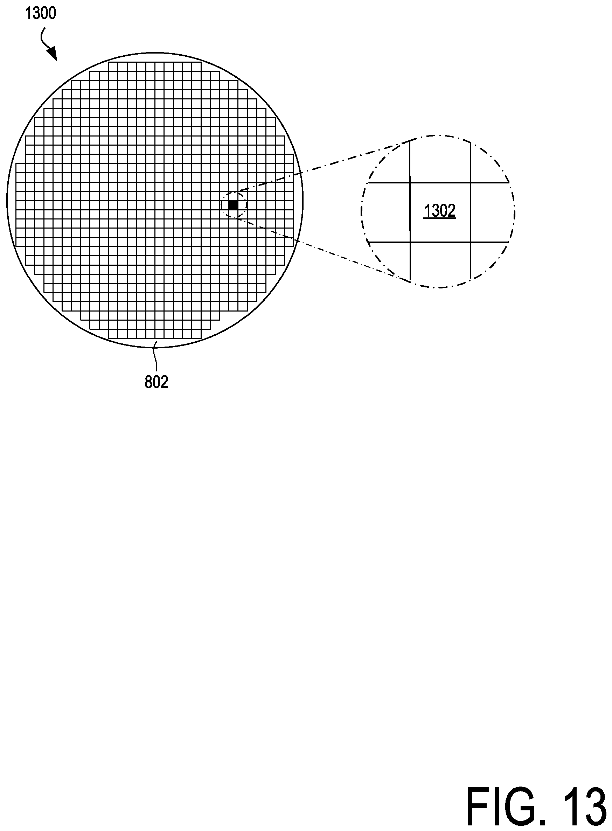

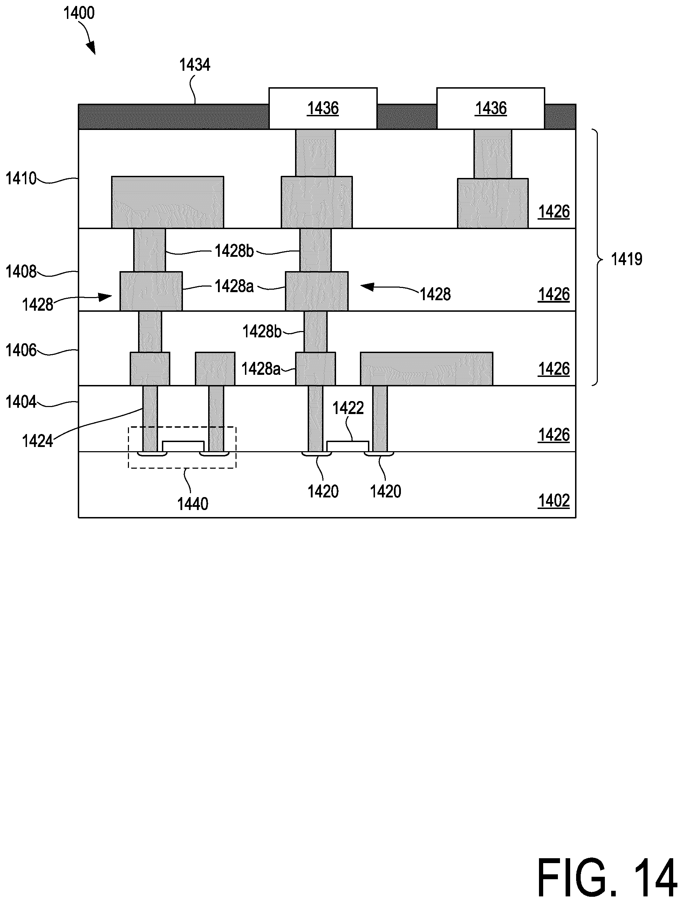

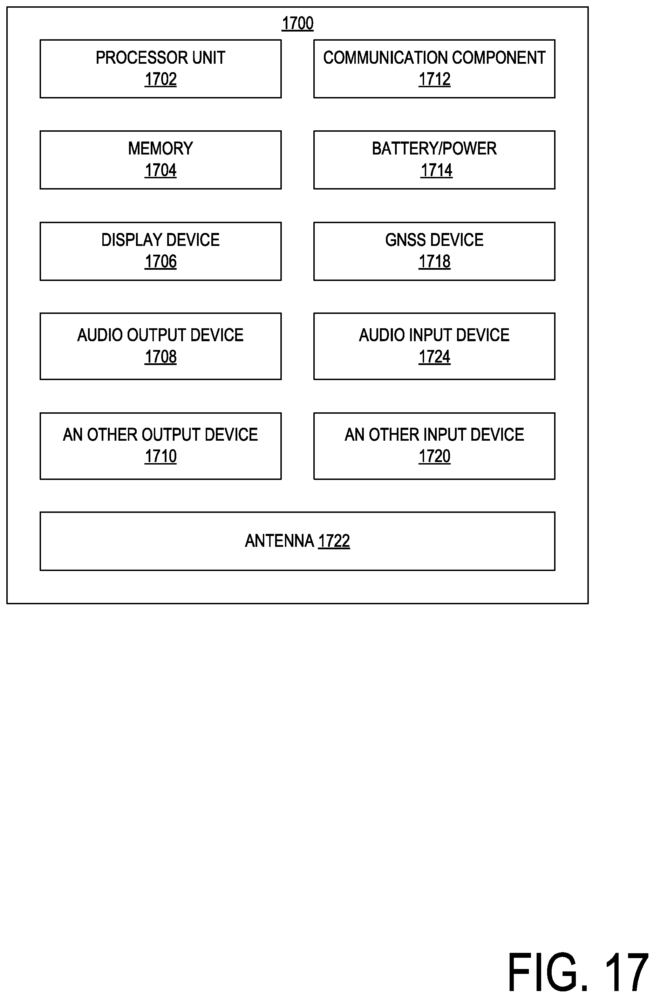

FIG. 13 is a top view of a wafer 1300 and dies 1302 that may include in any of the ribbon FETs 100 disclosed herein. The wafer 1300 may be composed of semiconductor material and may include one or more dies 1302 having integrated circuit structures formed on a surface of the wafer 1300. The individual dies 1302 may be a repeating unit of an integrated circuit product that includes any suitable integrated circuit. After the fabrication of the semiconductor product is complete, the wafer 1300 may undergo a singulation process in which the dies 1302 are separated from one another to provide discrete "chips" of the integrated circuit product. The die 1302 may include any of the ribbon FETs 100 disclosed herein. The die 1302 may include one or more transistors (e.g., some of the transistors 1440 of FIG. 14, discussed below), supporting circuitry to route electrical signals to the transistors, passive components (e.g., signal traces, resistors, capacitors, or inductors), and/or any other integrated circuit components. In some embodiments, the wafer 1300 or the die 1302 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1302. For example, a memory array formed by multiple memory devices may be formed on a same die 1302 as a processor unit (e.g., the processor unit 1702 of FIG. 17) or other logic that is configured to store information in the memory devices or execute instructions stored in the memory array. Various ones of the ribbon FETs 100 disclosed herein may be manufactured using a die-to-wafer assembly technique in which some dies are attached to a wafer 1300 that include others of the dies, and the wafer 1300 is subsequently singulated.

FIG. 14 is a cross-sectional side view of an integrated circuit device 1400 that may include any of the ribbon FETs 100 disclosed herein. One or more of the integrated circuit devices 1400 may be included in one or more dies 1302 (FIG. 13). The integrated circuit device 1400 may be formed on a die substrate 1402 (e.g., the wafer 1300 of FIG. 13) and may be included in a die (e.g., the die 1302 of FIG. 13). The die substrate 1402 may be a semiconductor substrate composed of semiconductor material systems including, for example, n-type or p-type materials systems (or a combination of both). The die substrate 1402 may include, for example, a crystalline substrate formed using a bulk silicon or a silicon-on-insulator (SOI) substructure. In some embodiments, the die substrate 1402 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1402. Although a few examples of materials from which the die substrate 1402 may be formed are described here, any material that may serve as a foundation for an integrated circuit device 1400 may be used. The die substrate 1402 may be part of a singulated die (e.g., the dies 1302 of FIG. 13) or a wafer (e.g., the wafer 1300 of FIG. 13).

The integrated circuit device 1400 may include one or more device layers 1404 disposed on the die substrate 1402. The device layer 1404 may include features of one or more transistors 1440 (e.g., metal oxide semiconductor field-effect transistors (MOSFETs)) formed on the die substrate 1402. The transistors 1440 may include, for example, one or more source and/or drain (S/D) regions 1420, a gate 1422 to control current flow between the S/D regions 1420, and one or more S/D contacts 1424 to route electrical signals to/from the S/D regions 1420. The transistors 1440 may include additional features not depicted for the sake of clarity, such as device isolation regions, gate contacts, and the like. The transistors 1440 are not limited to the type and configuration depicted in FIG. 14 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

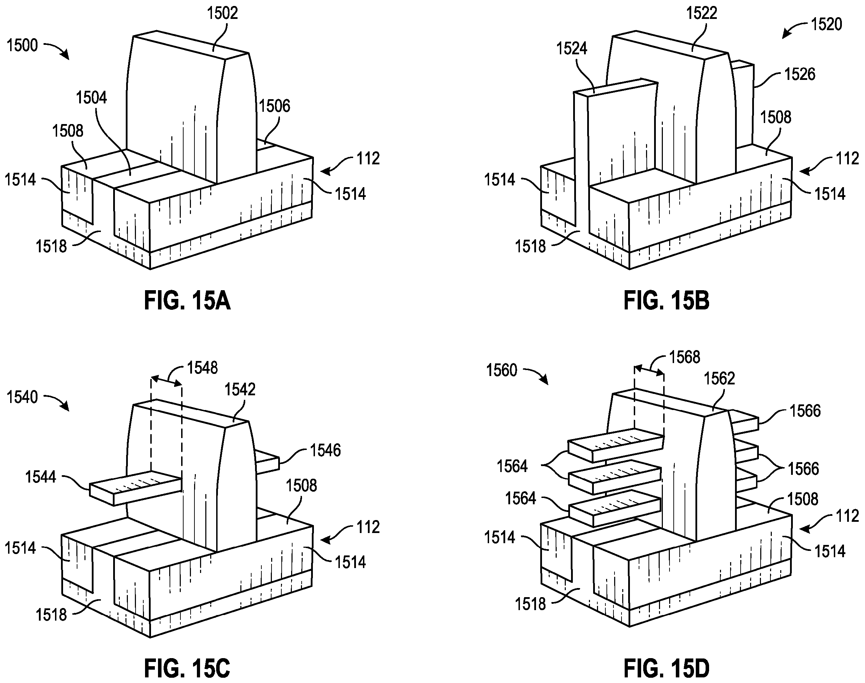

FIGS. 15A-15D are simplified perspective views of example planar, FinFET, gate-all-around, and stacked gate-all-around transistors. The transistors illustrated in FIGS. 15A-15D are formed on a substrate 1516 having a surface 1508. Isolation regions 1514 separate the source and drain regions of the transistors from other transistors and from a bulk region 1518 of the substrate 1516.

FIG. 15A is a perspective view of an example planar transistor 1500 comprising a gate 1502 that controls current flow between a source region 1504 and a drain region 1506. The transistor 1500 is planar in that the source region 1504 and the drain region 1506 are planar with respect to the substrate surface 1508.

FIG. 15B is a perspective view of an example FinFET transistor 1520 comprising a gate 1522 that controls current flow between a source region 1524 and a drain region 1526. The transistor 1520 is non-planar in that the source region 1524 and the drain region 1526 comprise "fins" that extend upwards from the substrate surface 1528. As the gate 1522 encompasses three sides of the semiconductor fin that extends from the source region 1524 to the drain region 1526, the transistor 1520 can be considered a tri-gate transistor. FIG. 15B illustrates one S/D fin extending through the gate 1522, but multiple S/D fins can extend through the gate of a FinFET transistor.

FIG. 15C is a perspective view of a gate-all-around (GAA) transistor 1540 comprising a gate 1542 that controls current flow between a source region 1544 and a drain region 1546. The transistor 1540 is non-planar in that the source region 1544 and the drain region 1546 are elevated from the substrate surface 1528.

FIG. 15D is a perspective view of a GAA transistor 1560 comprising a gate 1562 that controls current flow between multiple elevated source regions 1564 and multiple elevated drain regions 1566. The transistor 1560 is a stacked GAA transistor as the gate controls the flow of current between multiple elevated S/D regions stacked on top of each other. The transistors 1540 and 1560 are considered gate-all-around transistors as the gates encompass all sides of the semiconductor portions that extends from the source regions to the drain regions. The transistors 1540 and 1560 can alternatively be referred to as nanowire, nanosheet, or nanoribbon transistors depending on the width (e.g., widths 1548 and 1568 of transistors 1540 and 1560, respectively) of the semiconductor portions extending through the gate.

Returning to FIG. 14, a transistor 1440 may include a gate 1422 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1440 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1440 along the source-channel-drain direction, the gate electrode may consist of a U-shaped structure that includes a bottom portion substantially parallel to the surface of the die substrate 1402 and two sidewall portions that are substantially perpendicular to the top surface of the die substrate 1402. In other embodiments, at least one of the metal layers that form the gate electrode may simply be a planar layer that is substantially parallel to the top surface of the die substrate 1402 and does not include sidewall portions substantially perpendicular to the top surface of the die substrate 1402. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1420 may be formed within the die substrate 1402 adjacent to the gate 1422 of individual transistors 1440. The S/D regions 1420 may be formed using an implantation/diffusion process or an etching/deposition process, for example. In the former process, dopants such as boron, aluminum, antimony, phosphorous, or arsenic may be ion-implanted into the die substrate 1402 to form the S/D regions 1420. An annealing process that activates the dopants and causes them to diffuse farther into the die substrate 1402 may follow the ion-implantation process. In the latter process, the die substrate 1402 may first be etched to form recesses at the locations of the S/D regions 1420. An epitaxial deposition process may then be carried out to fill the recesses with material that is used to fabricate the S/D regions 1420. In some implementations, the S/D regions 1420 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1420 may be formed using one or more alternate semiconductor materials such as germanium or a group III-V material or alloy. In further embodiments, one or more layers of metal and/or metal alloys may be used to form the S/D regions 1420.

Electrical signals, such as power and/or input/output (I/O) signals, may be routed to and/or from the devices (e.g., transistors 1440) of the device layer 1404 through one or more interconnect layers disposed on the device layer 1404 (illustrated in FIG. 14 as interconnect layers 1406-1410). For example, electrically conductive features of the device layer 1404 (e.g., the gate 1422 and the S/D contacts 1424) may be electrically coupled with the interconnect structures 1428 of the interconnect layers 1406-1410. The one or more interconnect layers 1406-1410 may form a metallization stack (also referred to as an "ILD stack") 1419 of the integrated circuit device 1400.

The interconnect structures 1428 may be arranged within the interconnect layers 1406-1410 to route electrical signals according to a wide variety of designs; in particular, the arrangement is not limited to the particular configuration of interconnect structures 1428 depicted in FIG. 14. Although a particular number of interconnect layers 1406-1410 is depicted in FIG. 14, embodiments of the present disclosure include integrated circuit devices having more or fewer interconnect layers than depicted.

In some embodiments, the interconnect structures 1428 may include lines 1428a and/or vias 1428b filled with an electrically conductive material such as a metal. The lines 1428a may be arranged to route electrical signals in a direction of a plane that is substantially parallel with a surface of the die substrate 1402 upon which the device layer 1404 is formed. For example, the lines 1428a may route electrical signals in a direction in and out of the page and/or in a direction across the page. The vias 1428b may be arranged to route electrical signals in a direction of a plane that is substantially perpendicular to the surface of the die substrate 1402 upon which the device layer 1404 is formed. In some embodiments, the vias 1428b may electrically couple lines 1428a of different interconnect layers 1406-1410 together.

The interconnect layers 1406-1410 may include a dielectric material 1426 disposed between the interconnect structures 1428, as shown in FIG. 14. In some embodiments, dielectric material 1426 disposed between the interconnect structures 1428 in different ones of the interconnect layers 1406-1410 may have different compositions; in other embodiments, the composition of the dielectric material 1426 between different interconnect layers 1406-1410 may be the same. The device layer 1404 may include a dielectric material 1426 disposed between the transistors 1440 and a bottom layer of the metallization stack as well. The dielectric material 1426 included in the device layer 1404 may have a different composition than the dielectric material 1426 included in the interconnect layers 1406-1410; in other embodiments, the composition of the dielectric material 1426 in the device layer 1404 may be the same as a dielectric material 1426 included in any one of the interconnect layers 1406-1410.

A first interconnect layer 1406 (referred to as Metal 1 or "M1") may be formed directly on the device layer 1404. In some embodiments, the first interconnect layer 1406 may include lines 1428a and/or vias 1428b, as shown. The lines 1428a of the first interconnect layer 1406 may be coupled with contacts (e.g., the S/D contacts 1424) of the device layer 1404. The vias 1428b of the first interconnect layer 1406 may be coupled with the lines 1428a of a second interconnect layer 1408.

The second interconnect layer 1408 (referred to as Metal 2 or "M2") may be formed directly on the first interconnect layer 1406. In some embodiments, the second interconnect layer 1408 may include via 1428b to couple the lines 1428 of the second interconnect layer 1408 with the lines 1428a of a third interconnect layer 1410. Although the lines 1428a and the vias 1428b are structurally delineated with a line within individual interconnect layers for the sake of clarity, the lines 1428a and the vias 1428b may be structurally and/or materially contiguous (e.g., simultaneously filled during a dual-damascene process) in some embodiments.

The third interconnect layer 1410 (referred to as Metal 3 or "M3") (and additional interconnect layers, as desired) may be formed in succession on the second interconnect layer 1408 according to similar techniques and configurations described in connection with the second interconnect layer 1408 or the first interconnect layer 1406. In some embodiments, the interconnect layers that are "higher up" in the metallization stack 1419 in the integrated circuit device 1400 (i.e., farther away from the device layer 1404) may be thicker that the interconnect layers that are lower in the metallization stack 1419, with lines 1428a and vias 1428b in the higher interconnect layers being thicker than those in the lower interconnect layers.

The integrated circuit device 1400 may include a solder resist material 1434 (e.g., polyimide or similar material) and one or more conductive contacts 1436 formed on the interconnect layers 1406-1410. In FIG. 14, the conductive contacts 1436 are illustrated as taking the form of bond pads. The conductive contacts 1436 may be electrically coupled with the interconnect structures 1428 and configured to route the electrical signals of the transistor(s) 1440 to external devices. For example, solder bonds may be formed on the one or more conductive contacts 1436 to mechanically and/or electrically couple an integrated circuit die including the integrated circuit device 1400 with another component (e.g., a printed circuit board). The integrated circuit device 1400 may include additional or alternate structures to route the electrical signals from the interconnect layers 1406-1410; for example, the conductive contacts 1436 may include other analogous features (e.g., posts) that route the electrical signals to external components.

In some embodiments in which the integrated circuit device 1400 is a double-sided die, the integrated circuit device 1400 may include another metallization stack (not shown) on the opposite side of the device layer(s) 1404. This metallization stack may include multiple interconnect layers as discussed above with reference to the interconnect layers 1406-1410, to provide conductive pathways (e.g., including conductive lines and vias) between the device layer(s) 1404 and additional conductive contacts (not shown) on the opposite side of the integrated circuit device 1400 from the conductive contacts 1436.

In other embodiments in which the integrated circuit device 1400 is a double-sided die, the integrated circuit device 1400 may include one or more through silicon vias (TSVs) through the die substrate 1402; these TSVs may make contact with the device layer(s) 1404, and may provide conductive pathways between the device layer(s) 1404 and additional conductive contacts (not shown) on the opposite side of the integrated circuit device 1400 from the conductive contacts 1436. In some embodiments, TSVs extending through the substrate can be used for routing power and ground signals from conductive contacts on the opposite side of the integrated circuit device 1400 from the conductive contacts 1436 to the transistors 1440 and any other components integrated into the die 1400, and the metallization stack 1419 can be used to route I/O signals from the conductive contacts 1436 to transistors 1440 and any other components integrated into the die 1400.

Multiple integrated circuit devices 1400 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

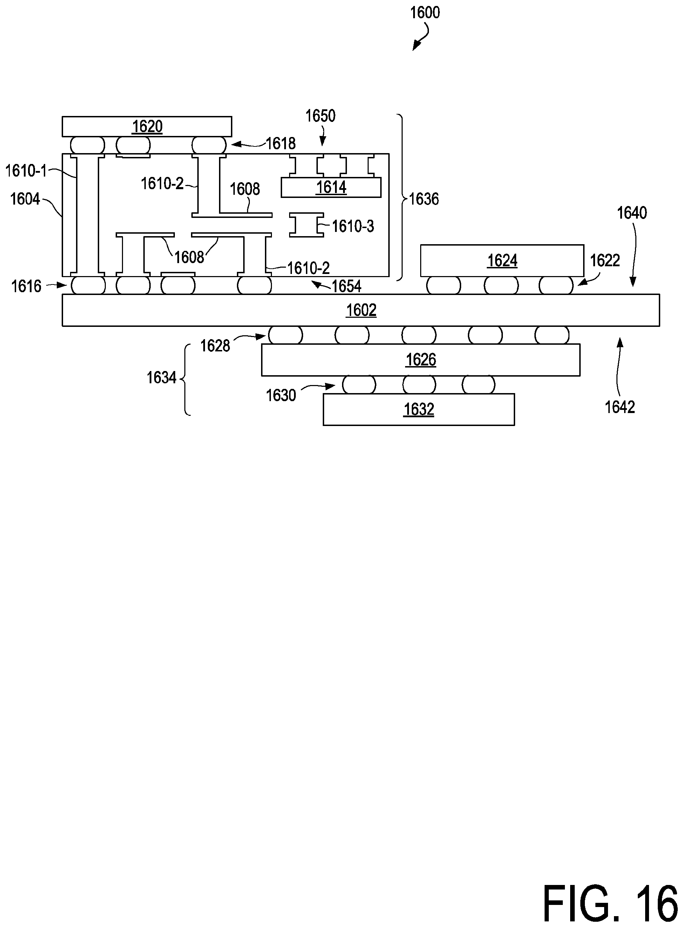

FIG. 16 is a cross-sectional side view of an integrated circuit device assembly 1600 that may include any of the ribbon FETs 100 disclosed herein. The integrated circuit device assembly 1600 includes a number of components disposed on a circuit board 1602 (which may be a motherboard, system board, mainboard, etc.). The integrated circuit device assembly 1600 includes components disposed on a first face 1640 of the circuit board 1602 and an opposing second face 1642 of the circuit board 1602; generally, components may be disposed on one or both faces 1640 and 1642.

In some embodiments, the circuit board 1602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1602. In other embodiments, the circuit board 1602 may be a non-PCB substrate. The integrated circuit device assembly 1600 illustrated in FIG. 16 includes a package-on-interposer structure 1636 coupled to the first face 1640 of the circuit board 1602 by coupling components 1616. The coupling components 1616 may electrically and mechanically couple the package-on-interposer structure 1636 to the circuit board 1602, and may include solder balls (as shown in FIG. 16), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1636 may include an integrated circuit component 1620 coupled to an interposer 1604 by coupling components 1618. The coupling components 1618 may take any suitable form for the application, such as the forms discussed above with reference to the coupling components 1616. Although a single integrated circuit component 1620 is shown in FIG. 16, multiple integrated circuit components may be coupled to the interposer 1604; indeed, additional interposers may be coupled to the interposer 1604. The interposer 1604 may provide an intervening substrate used to bridge the circuit board 1602 and the integrated circuit component 1620.

The integrated circuit component 1620 may be a packaged or unpacked integrated circuit product that includes one or more integrated circuit dies (e.g., the die 1302 of FIG. 13, the integrated circuit device 1400 of FIG. 14) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1620, a single monolithic integrated circuit die comprises solder bumps attached to contacts on the die. The solder bumps allow the die to be directly attached to the interposer 1604. The integrated circuit component 1620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1620 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1604 may spread connections to a wider pitch or reroute a connection to a different connection. For example, the interposer 1604 may couple the integrated circuit component 1620 to a set of ball grid array (BGA) conductive contacts of the coupling components 1616 for coupling to the circuit board 1602. In the embodiment illustrated in FIG. 16, the integrated circuit component 1620 and the circuit board 1602 are attached to opposing sides of the interposer 1604; in other embodiments, the integrated circuit component 1620 and the circuit board 1602 may be attached to a same side of the interposer 1604. In some embodiments, three or more components may be interconnected by way of the interposer 1604.

In some embodiments, the interposer 1604 may be formed as a PCB, including multiple metal layers separated from one another by layers of dielectric material and interconnected by electrically conductive vias. In some embodiments, the interposer 1604 may be formed of an epoxy resin, a fiberglass-reinforced epoxy resin, an epoxy resin with inorganic fillers, a ceramic material, or a polymer material such as polyimide. In some embodiments, the interposer 1604 may be formed of alternate rigid or flexible materials that may include the same materials described above for use in a semiconductor substrate, such as silicon, germanium, and other group III-V and group IV materials. The interposer 1604 may include metal interconnects 1608 and vias 1610, including but not limited to through hole vias 1610-1 (that extend from a first face 1650 of the interposer 1604 to a second face 1654 of the interposer 1604), blind vias 1610-2 (that extend from the first or second faces 1650 or 1654 of the interposer 1604 to an internal metal layer), and buried vias 1610-3 (that connect internal metal layers).

In some embodiments, the interposer 1604 can comprise a silicon interposer. Through silicon vias (TSV) extending through the silicon interposer can connect connections on a first face of a silicon interposer to an opposing second face of the silicon interposer. In some embodiments, an interposer 1604 comprising a silicon interposer can further comprise one or more routing layers to route connections on a first face of the interposer 1604 to an opposing second face of the interposer 1604.

The interposer 1604 may further include embedded devices 1614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1604. The package-on-interposer structure 1636 may take the form of any of the package-on-interposer structures known in the art.

The integrated circuit device assembly 1600 may include an integrated circuit component 1624 coupled to the first face 1640 of the circuit board 1602 by coupling components 1622. The coupling components 1622 may take the form of any of the embodiments discussed above with reference to the coupling components 1616, and the integrated circuit component 1624 may take the form of any of the embodiments discussed above with reference to the integrated circuit component 1620.

The integrated circuit device assembly 1600 illustrated in FIG. 16 includes a package-on-package structure 1634 coupled to the second face 1642 of the circuit board 1602 by coupling components 1628. The package-on-package structure 1634 may include an integrated circuit component 1626 and an integrated circuit component 1632 coupled together by coupling components 1630 such that the integrated circuit component 1626 is disposed between the circuit board 1602 and the integrated circuit component 1632. The coupling components 1628 and 1630 may take the form of any of the embodiments of the coupling components 1616 discussed above, and the integrated circuit components 1626 and 1632 may take the form of any of the embodiments of the integrated circuit component 1620 discussed above. The package-on-package structure 1634 may be configured in accordance with any of the package-on-package structures known in the art.

FIG. 17 is a block diagram of an example electrical device 1700 that may include one or more of the ribbon FETs 100 disclosed herein. For example, any suitable ones of the components of the electrical device 1700 may include one or more of the integrated circuit device assemblies 1600, integrated circuit components 1620, integrated circuit devices 1400, or integrated circuit dies 1302 disclosed herein, and may be arranged in any of the ribbon FETs 100 disclosed herein. A number of components are illustrated in FIG. 17 as included in the electrical device 1700, but any one or more of these components may be omitted or duplicated, as suitable for the application. In some embodiments, some or all of the components included in the electrical device 1700 may be attached to one or more motherboards mainboards, or system boards. In some embodiments, one or more of these components are fabricated onto a single system-on-a-chip (SoC) die.

Additionally, in various embodiments, the electrical device 1700 may not include one or more of the components illustrated in FIG. 17, but the electrical device 1700 may include interface circuitry for coupling to the one or more components. For example, the electrical device 1700 may not include a display device 1706, but may include display device interface circuitry (e.g., a connector and driver circuitry) to which a display device 1706 may be coupled. In another set of examples, the electrical device 1700 may not include an audio input device 1724 or an audio output device 1708, but may include audio input or output device interface circuitry (e.g., connectors and supporting circuitry) to which an audio input device 1724 or audio output device 1708 may be coupled.

The electrical device 1700 may include one or more processor units 1702 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1700 may include a memory 1704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1704 may include memory that is located on the same integrated circuit die as the processor unit 1702. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1700 can comprise one or more processor units 1702 that are heterogeneous or asymmetric to another processor unit 1702 in the electrical device 1700. There can be a variety of differences between the processing units 1702 in a system in terms of a spectrum of metrics of merit including architectural, microarchitectural, thermal, power consumption characteristics, and the like. These differences can effectively manifest themselves as asymmetry and heterogeneity among the processor units 1702 in the electrical device 1700.

In some embodiments, the electrical device 1700 may include a communication component 1712 (e.g., one or more communication components). For example, the communication component 1712 can manage wireless communications for the transfer of data to and from the electrical device 1700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1712 may operate in accordance with other wireless protocols in other embodiments. The electrical device 1700 may include an antenna 1722 to facilitate wireless communications and/or to receive other wireless communications (such as AM or FM radio transmissions).

In some embodiments, the communication component 1712 may manage wired communications, such as electrical, optical, or any other suitable communication protocols (e.g., IEEE 802.3 Ethernet standards). As noted above, the communication component 1712 may include multiple communication components. For instance, a first communication component 1712 may be dedicated to shorter-range wireless communications such as Wi-Fi or Bluetooth, and a second communication component 1712 may be dedicated to longer-range wireless communications such as global positioning system (GPS), EDGE, GPRS, CDMA, WiMAX, LTE, EV-DO, or others. In some embodiments, a first communication component 1712 may be dedicated to wireless communications, and a second communication component 1712 may be dedicated to wired communications.

The electrical device 1700 may include battery/power circuitry 1714. The battery/power circuitry 1714 may include one or more energy storage devices (e.g., batteries or capacitors) and/or circuitry for coupling components of the electrical device 1700 to an energy source separate from the electrical device 1700 (e.g., AC line power).

The electrical device 1700 may include a display device 1706 (or corresponding interface circuitry, as discussed above). The display device 1706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1700 may include an audio output device 1708 (or corresponding interface circuitry, as discussed above). The audio output device 1708 may include any embedded or wired or wirelessly connected external device that generates an audible indicator, such as speakers, headsets, or earbuds.

The electrical device 1700 may include an audio input device 1724 (or corresponding interface circuitry, as discussed above). The audio input device 1724 may include any embedded or wired or wirelessly connected device that generates a signal representative of a sound, such as microphones, microphone arrays, or digital instruments (e.g., instruments having a musical instrument digital interface (MIDI) output). The electrical device 1700 may include a Global Navigation Satellite System (GNSS) device 1718 (or corresponding interface circuitry, as discussed above), such as a Global Positioning System (GPS) device. The GNSS device 1718 may be in communication with a satellite-based system and may determine a geolocation of the electrical device 1700 based on information received from one or more GNSS satellites, as known in the art.

The electrical device 1700 may include an other output device 1710 (or corresponding interface circuitry, as discussed above). Examples of the other output device 1710 may include an audio codec, a video codec, a printer, a wired or wireless transmitter for providing information to other devices, or an additional storage device.

The electrical device 1700 may include an other input device 1720 (or corresponding interface circuitry, as discussed above). Examples of the other input device 1720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1700 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1700 may be any other electronic device that processes data. In some embodiments, the electrical device 1700 may comprise multiple discrete physical components. Given the range of devices that the electrical device 1700 can be manifested as in various embodiments, in some embodiments, the electrical device 1700 can be referred to as a computing device or a computing system.

### EXAMPLES

Illustrative examples of the technologies disclosed herein are provided below. An embodiment of the technologies may include any one or more, and any combination of, the examples described below.

Example 1 includes a device comprising one or more channel fins, wherein individual channel fins of the one or more channel fins comprise a first perovskite layer and a second perovskite layer; an oxide layer adjacent individual channel fins of the one or more channel fins, wherein, at a cross-section, the oxide layer is above and below individual channel fins of the one or more channel fins; and a gate layer adjacent the oxide layer, wherein, at a cross-section, the gate layer is above and below individual channel fins of the one or more channel fins.

Example 2 includes the subject matter of Example 1, and wherein the first perovskite layer comprises (i) barium or strontium and (ii) tin or titanium.

Example 3 includes the subject matter of any of Examples 1 and 2, and wherein the second perovskite layer comprises a lanthanide.

Example 4 includes the subject matter of any of Examples 1-3, and wherein the second perovskite layer comprises scandium, aluminum, or indium.

Example 5 includes the subject matter of any of Examples 1-4, and wherein a two-dimensional electron gas is formed at an interface between the first perovskite layer and the second perovskite layer.

Example 6 includes the subject matter of any of Examples 1-5, and wherein a two-dimensional hole gas is formed at an interface between the first perovskite layer and the second perovskite layer.

Example 7 includes the subject matter of any of Examples 1-6, and wherein the first perovskite layer has a thickness of 5-20 nanometers, wherein the second perovskite layer has a thickness of 5-20 nanometers.

Example 8 includes the subject matter of any of Examples 1-7, and wherein at least part of the oxide layer is ferroelectric.

Example 9 includes the subject matter of any of Examples 1-8, and further including a second one or more channel fins above the one or more channel fins, wherein individual channel fins of the second one or more channel fins comprise a third perovskite layer and a fourth perovskite layer, wherein the one or more channel fins forms part of an NMOS transistor and the second one or more channel fins forms part of a PMOS transistor.

Example 10 includes the subject matter of any of Examples 1-9, and wherein a two-dimensional electron gas is formed at an interface between the first perovskite layer and the second perovskite layer, wherein a two-dimensional hole gas is formed at an interface between the third perovskite layer and the fourth perovskite layer.

Example 11 includes the subject matter of any of Examples 1-10, and further including a first metallic contact adjacent a first end of individual channel fins of the one or more channel fins, and a first metallic contact adjacent a second end of individual channel fins of the one or more channel fins opposite the first end.

Example 12 includes a processor comprising the device of any of Examples 1-11.

Example 13 includes a system comprising the processor of Exanple 12 and one or more memory devices.

Example 14 includes a device comprising a ribbon field effect transistor (FET) comprising a one or more channel fins, wherein individual channel fins of the one or more channel fins comprise a first perovskite layer and a second perovskite layer; an oxide layer adjacent the one or more channel fins; and a gate layer adjacent the oxide layer.

Example 15 includes the subject matter of Example 14, and wherein the first perovskite layer comprises (i) barium or strontium and (ii) tin or titanium.

Example 16 includes the subject matter of any of Examples 14 and 15, and wherein the second perovskite layer comprises a lanthanide.

Example 17 includes the subject matter of any of Examples 14-16, and wherein the second perovskite layer comprises scandium, aluminum, or indium.

Example 18 includes the subject matter of any of Examples 14-17, and wherein a two-dimensional electron gas is formed at an interface between the first perovskite layer and the second perovskite layer.

Example 19 includes the subject matter of any of Examples 14-18, and wherein a two-dimensional hole gas is formed at an interface between the first perovskite layer and the second perovskite layer.

Example 20 includes the subject matter of any of Examples 14-19, and wherein the first perovskite layer has a thickness of 5-20 nanometers, wherein the second perovskite layer has a thickness of 5-20 nanometers.

Example 21 includes the subject matter of any of Examples 14-20, and wherein at least part of the oxide layer is ferroelectric.

Example 22 includes the subject matter of any of Examples 14-21, and further including a second one or more channel fins above the one or more channel fins, wherein individual channel fins of the second one or more channel fins comprise a third perovskite layer and a fourth perovskite layer, wherein the one or more channel fins forms part of an NMOS transistor and the second one or more channel fins forms part of a PMOS transistor.

Example 23 includes the subject matter of any of Examples 14-22, and wherein a two-dimensional electron gas is formed at an interface between the first perovskite layer and the second perovskite layer, wherein a two-dimensional hole gas is formed at an interface between the third perovskite layer and the fourth perovskite layer.

Example 24 includes the subject matter of any of Examples 14-23, and further including a first metallic contact adjacent a first end of individual channel fins of the one or more channel fins, and a first metallic contact adjacent a second end of individual channel fins of the one or more channel fins opposite the first end.

Example 25 includes a processor comprising the device of any of Examples 14-24.

Example 26 includes a system comprising the processor of Example 25 and one or more memory devices.

Example 27 includes a device comprising a ribbon field effect transistor (FET) comprising a one or more channel fins, wherein individual channel fins of the one or more channel fins comprise a first perovskite layer and a second perovskite layer; and a gate layer adjacent individual fins of the one or more channel fins.

Example 28 includes the subject matter of Example 27, and wherein at least part of the first perovskite layer of individual channel fins of the one or more channel fins forms a channel for the FET, wherein at least part of the first perovskite layer of individual channel fins of the one or more channel fins between the corresponding channel and the gate layer is a dielectric, wherein at least part of the second perovskite layer of individual channel fins of the one or more channel fins is a dielectric.

Example 29 includes the subject matter of any of Examples 27 and 28, and wherein the first perovskite layer comprises (i) barium or strontium and (ii) tin or titanium.

Example 30 includes the subject matter of any of Examples 27-29, and wherein the second perovskite layer comprises a lanthanide.

Example 31 includes the subject matter of any of Examples 27-30, and wherein the second perovskite layer comprises scandium, aluminum, or indium.

Example 32 includes the subject matter of any of Examples 27-31, and wherein a two-dimensional electron gas is formed at an interface between the first perovskite layer and the second perovskite layer.

Example 33 includes the subject matter of any of Examples 27-32, and wherein a two-dimensional hole gas is formed at an interface between the first perovskite layer and the second perovskite layer.

Example 34 includes the subject matter of any of Examples 27-33, and wherein the first perovskite layer has a thickness of 5-20 nanometers, wherein the second perovskite layer has a thickness of 5-20 nanometers.

Example 35 includes the subject matter of any of Examples 27-34, and further including a second one or more channel fins above the one or more channel fins, wherein individual channel fins of the second one or more channel fins comprise a third perovskite layer and a fourth perovskite layer, wherein the one or more channel fins forms part of an NMOS transistor and the second one or more channel fins forms part of a PMOS transistor.

Example 36 includes the subject matter of any of Examples 27-35, and wherein a two-dimensional electron gas is formed at an interface between the first perovskite layer and the second perovskite layer, wherein a two-dimensional hole gas is formed at an interface between the third perovskite layer and the fourth perovskite layer.

Example 37 includes the subject matter of any of Examples 27-36, and further including a first metallic contact adjacent a first end of individual channel fins of the one or more channel fins, and a first metallic contact adjacent a second end of individual channel fins of the one or more channel fins opposite the first end.

Example 38 includes a processor comprising the device of any of Examples 27-37.

Example 39 includes a system comprising the processor of Example 38 and one or more memory devices.

## Claims

1. A device comprising:
one or more channel fins, wherein individual channel fins of the one or more channel fins comprise a first perovskite layer and a second perovskite layer;
an oxide layer adjacent individual channel fins of the one or more channel fins, wherein, at a cross-section, the oxide layer is above and below individual channel fins of the one or more channel fins; and
a gate layer adjacent the oxide layer, wherein, at a cross-section, the gate layer is above and below individual channel fins of the one or more channel fins.

2. The device of claim 1, wherein the first perovskite layer comprises (i) barium or strontium and (ii) tin or titanium.

3. The device of any of claims 1-2, wherein the second perovskite layer comprises a lanthanide.

4. The device of any of claims 1-3, wherein the second perovskite layer comprises scandium, aluminum, or indium.

5. The device of any of claims 1-4, wherein a two-dimensional electron gas is formed at an interface between the first perovskite layer and the second perovskite layer.

6. The device of any of claims 1-5, wherein a two-dimensional hole gas is formed at an interface between the first perovskite layer and the second perovskite layer.

7. The device of any of claims 1-6, wherein the first perovskite layer has a thickness of 5-20 nanometers, wherein the second perovskite layer has a thickness of 5-20 nanometers.

8. The device of any of claims 1-7, wherein at least part of the oxide layer is ferroelectric.

9. The device of any of claims 1-8, further comprising:
a second one or more channel fins above the one or more channel fins, wherein individual channel fins of the second one or more channel fins comprise a third perovskite layer and a fourth perovskite layer, wherein the one or more channel fins forms part of an NMOS transistor and the second one or more channel fins forms part of a PMOS transistor.

10. The device of claim 9, wherein a two-dimensional electron gas is formed at an interface between the first perovskite layer and the second perovskite layer, wherein a two-dimensional hole gas is formed at an interface between the third perovskite layer and the fourth perovskite layer.

11. The device of any of claims 1-10, further comprising:
a first metallic contact adjacent a first end of individual channel fins of the one or more channel fins, and
a first metallic contact adjacent a second end of individual channel fins of the one or more channel fins opposite the first end.

12. The device of any of claims 1-11, wherein the first perovskite layer comprises barium.

13. The device of any of claims 1-12, wherein the first perovskite layer comprises strontium.

14. A processor comprising the device of any of claims 1-13.

15. A system comprising the processor of claim 15 and one or more memory devices.
